# EUROPEAN PATENT SPECIFICATION

(11) **EP 4 270 477 B1**
(45) Date of publication and mention of the grant of the patent: **03.06.2026**
(21) Application number: 23169831.7
(22) Date of filing: 25.04.2023
(51) Int. Cl.: H01L 25/11, H01L 25/07, H01L 23/538, H01L 25/03, H01L 23/051, H01L 23/31, H01L 23/373, H01L 23/00, H01L 23/495

(54) **POWER MODULE AND METHOD FOR MANUFACTURING A POWER MODULE**
LEISTUNGSMODUL UND VERFAHREN ZUR HERSTELLUNG EINES LEISTUNGSMODULS
MODULE DE PUISSANCE ET PROCÉDÉ DE FABRICATION D'UN MODULE DE PUISSANCE

(30) Priority: 26.04.2022 WO PCT/EP2022/061026
(43) Date of publication of application: 01.11.2023
(73) Proprietor: Hitachi Energy Ltd, 8050 Zürich (CH)
(72) Inventor: LIU, Chunlei, 5452 Oberrohrdorf (CH); SALVATORE, Giovanni, 34170 Gorizia (IT); PAVLICEK, Niko, 8041 Zürich (CH)
(74) Representative: Epping - Hermann - Fischer

(56) References cited:
- WO-A1-2020/078967
- WO-A1-2022/058313
- US-A1- 2012 025 298
- US-A1- 2013 020 694
- US-A1- 2017 110 978
- US-A1- 2021 351 168

## Description

The present disclosure relates to a power module and a method for manufacturing a power module. The power module can be used in power electronic applications, such as motor drives or power converters in electric vehicles (EV), for example.

The power module is a half-bridge power module comprising two groups of power semiconductor devices, wherein one group comprises one or more high-side devices and the other group comprises one or more low-side devices.

EP 2 988 328 A1 and EP 3 246 945 A1 disclose examples of power modules in half-bridge configuration.

US 2017/110978 A1 discloses a power module comprising a first sub-module formed as a high-voltage-side switching element and a second sub-module formed as a low-voltage-side switching element, wherein the sub-modules are oriented face-up and face-down. US 2013/020694 A1 discloses a power module package comprising switch units placed in a planar face-up and face-down configuration.

US 2012/025298 A1 discloses a manufacturing process of a wafer level chip scale package (WLCSP), wherein the resulting individual devices comprise a gate pad, a source pad and a drain contact both at a front surface and a back surface to allow connections to be inspected from different sides.

WO 2020/078967 A1 discloses a half bridge module having a plurality of half bridge units, each half bridge unit forming a critical mesh via a first switching element, a second switching element and a capacitor unit. Each critical mesh at least intermittently generates a magnetic field, wherein two adjacent half bridge units are arranged such that the magnetic fields substantially compensate each other. WO 2022/058313 A1 discloses a molded power module having a laminated DC-link structure.

US 2021 /351168 A1 discloses a semiconductor module wherein a low side switch and a high side switch are arranged laterally adjacent one another and coupled in series between a ground package pad and a voltage input package pad.

Embodiments of the disclosure relate to an improved power module. At least some of the embodiments may have a simplified design and/or an improved switching behavior. According to a first aspect, a half-bridge power module according to claim 1 is provided.

Each of the switching devices may be in the form of an IGBT, MOSFET, JFET, HEMT or MISFET, for example. Depending on the type of the switching device, the term source contact or emitter contact is used and the term drain contact or collector contact is used.

The power module may comprise several high side and several low side switching devices. The drain or collector contacts of the same side may be oriented in the same direction. As an example, the drain or collector contacts of the low side switching devices may be oriented towards the metallizations and the drain or collector contacts of the high side switching devices may be oriented in the opposite direction. In other embodiments, the drain or collector contact of the high side switching devices may be oriented towards the metallizations and the drain or collector contacts of the low side switching devices may be oriented in the opposite direction.

The power module may comprise at least two columns of low side switching devices and at least two columns of high side switching devices. The layout may be mirror-symmetric relative to a plane perpendicular to a main surface of the substrate.

The switching devices is provided in the form of chip-scale packaged (CSP) units. Each unit may comprise only a single switching device. It is also possible that one or more of the units comprise several switching devices. As an example, a unit may comprise several switching devices of the same side connected in parallel.

According to the claimed invention, the CSP units have an identical structure. In this case, the design of the power module is simplified and manufacturing costs can be reduced. When manufacturing the power module, identical switching devices can be provided and connected in different orientations to the metallizations.

According to a second alternative, which is not in accordance with the claimed invention, the structure of the high side switching device is different from the structure of the low side switching device, wherein the structure of gate contacts is different. For one of the switching devices, the gate contact may be arranged for further connection on the first side and for the other switching device, the gate contact may be arranged for further connection, on the second side. In this case, the gate contacts of both switching devices may be directly connected to a gate terminal above the switching devices.

The high side and low side switching devices may be connected to the same one of the metallizations. Due to the direct connection of the switching devices to the same metallization, the loop inductances of the power module is reduced and a low parasitic inductance is achieved.

It is also possible that the high side and low side switching devices are located on and electrically connected to different metallizations. The different metallizations may be located on separate substrates. The substrates may have an identical layout. This simplifies the manufacturing of the substrates. Furthermore, the switching devices can be assembled and tested independently from each other and electrically connected in a later step. The metallizations may be electrically connected by an interconnection member, for example. The interconnection member may be in the form of a wire bond or a metal clip, for example.

The power module comprises a DC+ terminal and a DC- terminal. A part of the DC+ terminal is located between a part of the DC- terminal and the low-side switching device or a part of the DC- terminal is located between a part of the DC+ terminal and the high-side switching device.

The part of the terminal may be a main connection part. The main connection part may be arranged in the connection of the switching devices with the terminal portion where the external contact is to be connected.

One or both parts have the shape of a plate. The parts are parallel to a main plane of the substrate. The part of the DC- terminal covers the part of the DC+ terminal or vice versa. It covers the other part completely. The part of the terminal covering the part of the other terminal has a broader width than the part of the other terminal. This arrangement may reduce the loop inductance of the power module and enables a low parasitic inductance.

A terminal structure may comprise one or more terminals. The switching devices may be located between the terminal structure and the substrates. The terminals may electrically contact the switching devices from a top side and the metallizations may electrically contact the switching devices from a bottom side. Each of the source or emitter contacts and each of the drain or collector contacts may be either directly connected to one of the metallizations or to one of the terminals. Also the gate contacts may be either directly connected to one of the metallizations or to one of the terminals. This enables a design where the switching devices are not connected by wire bonds.

According to a further aspect, a method for manufacturing a half-bridge power module according to claim 10 is provided.

The thus manufactured power module may have any structural and functional characteristics of the power module described in the foregoing.

The switching devices are provided by chip-scale packaged units. Identical switching devices are provided for the high side switching device and the low side switching device. Not in accordance with the invention, different switching devices are provided for the different sides.

The switching devices may be located on the same metallization. In a further embodiment, the switching devices may be located on different metallizations and tested independently from each other. After that, the metallizations may be connected by an interconnection member.

The present disclosure comprises several aspects and embodiments. Every feature described with respect to one of the aspects and embodiments is also disclosed herein with respect to the other aspects and embodiments, even if the respective feature is not explicitly mentioned in this context.

Further features, refinements and expediencies become apparent from the following description of the exemplary embodiments in connection with the figures. In the figures, elements of the same structure and/or functionality may be referenced by the same reference signs. It is to be understood that the embodiments shown in the figures are illustrative representations and are not necessarily drawn to scale.
- Figure 1: is a sectional view of a switching device,
- Figure 2: is a top view of a power module according to an embodiment,
- Figure 3: is a schematic circuit diagram of a half-bridge,
- Figure 4: is a sectional view of a power module with terminals according to an embodiment,
- Figure 5: is a sectional view of the power module of Figure 4 with an illustration of commutation paths,
- Figure 6: is a sectional view of a power module with terminals according to a further embodiment,
- Figure 7: is a perspective view of a power module according to a further embodiment,
- Figure 8A: is a perspective view of the power module of Figure 7 with a first terminal layer,
- Figure 8B: is a perspective view of the power module of Figure 7 with a second terminal layer,
- Figure 8C: is a perspective view of the power module of Figure 7 with a third terminal layer,
- Figure 9A: is a diagram of coupling inductances for the high side switching devices of the embodiment of Figure 7,
- Figure 9B: is a diagram of coupling inductances for the low side switching devices of the embodiment of Figure 7,
- Figure 10: is a sectional view of a power module according to a non-claimed example.

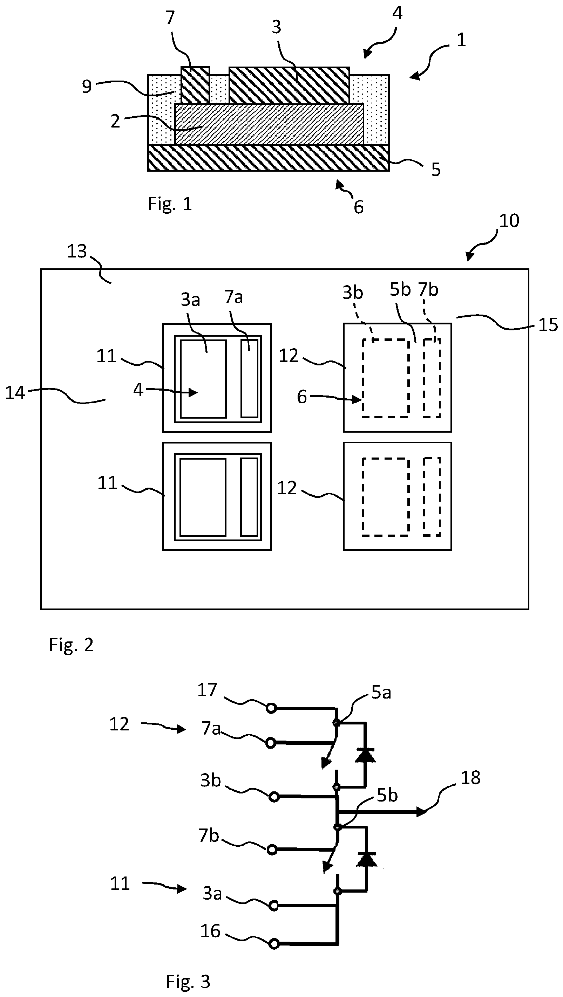

Figure 1 shows a switching device 1 comprising a semiconductor body 2, a source or emitter contact 3 on a first side 4 and a drain or collector contact 5 on an opposite second side 6. The switching device 1 also comprises a gate contact 7 which is located on the first side 4.

The switching device 1 may be in the form of an IGBT, MOSFET, JFET, HEMT or MISFET, for example. Depending on the type of the switching device 1, the term source contact or emitter contact is used and the term drain contact or collector contact is used. In the following, for a simplified nomenclature, the source or emitter contact 3 will be referred to as "source" contact 3 and the drain or collector contact 5 will be referred to as "drain" contact 5. This has to be understood such that also an emitter contact and a collector contact is included in this nomenclature.

The switching device 1 is in the form of a unit 8, which in accordance with embodiments of the invention, is a chip-scale packaged (CSP) unit. The semiconductor body 2 and parts of the contacts 3, 5, 7 are embedded in an insulating material 9, such as epoxy resin, for example. The semiconductor body 2 may be pre-packaged by PCB embedding or epoxy molding, for example. The contacts 3, 5, 7 protrude out of the insulating material 9. Several pre-manufactured units 8 may be provided in an assembly process and assembled to form a power module in the form of a half-bridge.

The CSP structure with top and bottom metallization provides additional thermal capacitance that is beneficial in overload and surge conditions.

Figure 2 shows a power module 10 comprising several low side switching devices 11 and several high side switching devices 12. The switching devices 11, 12 are connected to form a half-bridge. The switching devices 11, 12 are arranged in two rows, each row comprising a low side switching device 11 and a high side switching device 12, and in two columns, one of the columns comprising only low side switching devices 11 and the other one of the columns comprising only high side switching devices 12. All of the switching devices 11, 12 may have the layout of the switching device 1 as shown in Figure 1.

The switching devices 11, 12 are located on a substrate 13, which may comprise a ceramic material, for example. A metal-ceramic substrate enhances the cooling performance. The substrate 13 comprises a metallization 14 and a further metallization 15 for electrical connection of the switching devices 11, 12. The power module 10 may comprise only a single substrate 13.

The low side switching devices 11 are located such that the first side 4 points upwards, i.e., away from the substrate 13 and the second side 6 points downwards, i.e., towards the substrate 13. The drain contact 5a of each of the low side switching devices 11 is connected to the metallization 14. The source contacts 3a and the gate contacts 7a point upwards and can be connected to terminals.

The high side switching devices 12 are flipped such that the first side 4 points downwards and the second side 6 points upwards. Thus, the drain contact 5b points upwards and can be connected to a terminal, for example. The source contact 3b is connected to the metallization 14 and the gate contact 7b is connected to the further metallization 15. The metallization 14 is provided for conducting AC current. The source contact 3b is located at a distance from the associated gate contact 7b which is at least as large as the distance between the metallization 14 and the further metallization 15 so that the respective electrical connections to the metallizations 14, 15 can be provided.

Accordingly, during the module assembly process, the same units 8 are provided and oriented differently for the high side switching devices 12 and the low side switching devices 11 such that the costs for manufacturing and testing can be lowered and the design is simplified.

The source contacts 3b of the high side switching devices 12 and the drain contacts 5a of the low side switching devices 11 are connected with the same substrate metallization 14. The substrate metallization 14 can then be connected to an AC terminal. The DC+ terminal and DC- terminal can be connected from the other side. Main connection parts of the terminals may be parallel to each other. This connection structure reduces the loop inductance of the power module 10 and enables a low parasitic inductance. Furthermore, a balanced gate signal inductance for each switching device is provided.

Figure 3 shows an electric circuit in the form of a half-bridge. The high side switching device 12 and the low side switching device 11 are connected in series between a DC+ terminal 17 and DC- terminal 16, wherein an AC terminal is connected to an emitter or source of the high side switching device 12 and to the collector or drain of the low side switching device 11.

The switching devices 11, 12 may be MOSFET switching devices and may comprise diodes connected between collectors 5a, 5b and emitters 3a, 3b, for example.

The half-bridge power module may comprise several low side switching devices 11 connected in parallel to each other and several high side switching devices 12 connected in parallel to each other as shown in Figure 2.

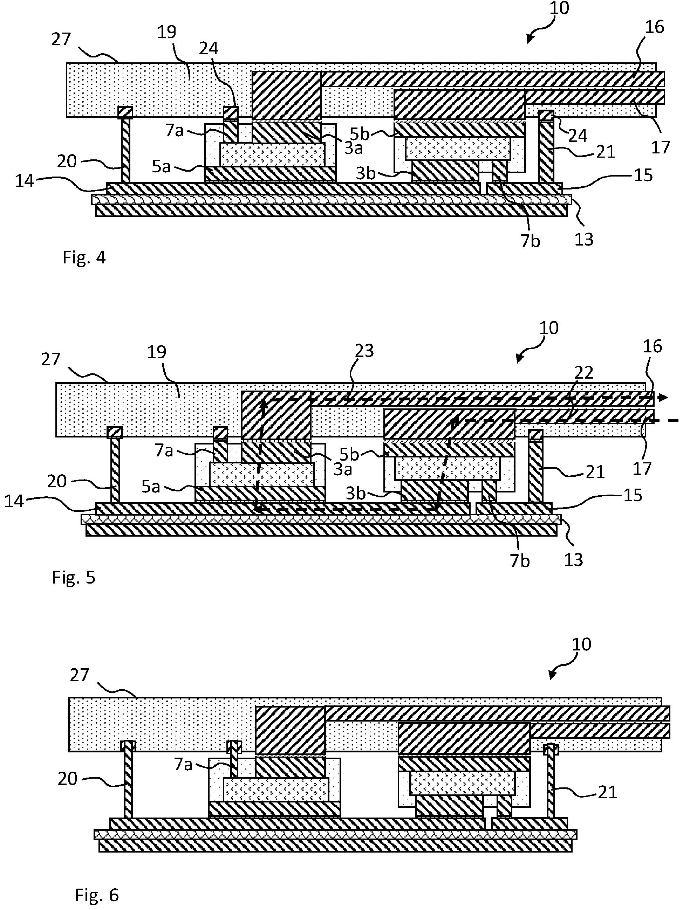

Figure 4 shows a power module 10 in a sectional view with a terminal structure. The layout may be the same as in the power module 10 of Figure 2.

The DC- terminal 16 and the DC+ terminal 17 are part of a terminal structure 27. The terminal structure 27 may be in the form of a printed circuit board (PCB) 19. In particular, the PCB 19 may be a thick copper PCB. The DC- terminal 16 is directly connected to the source contact 3a of the LS switching device 11. The connection may be formed by soldering or sintering, for example. An AC terminal (not shown here) may be connected directly to the metallization 14 at an edge of the substrate 13, for example. A direct connection includes that the respective terminals are integrally formed with a connection part which is directly connected to the respective contacts.

Furthermore, a connection structure 20 for connection to an auxiliary terminal for monitoring power at the source contact 3b of the high side switching device 12 and a connection structure 21 for connection to the gate contact 7b of the HS switching device 12 and controlling gate signals are shown. The connection structures 20, 21 are connected to the printed circuit board 19**.** The gate connection structure 21 is connected to a HS gate terminal 26 integrated in the PCB 19. The connection structures 20, 21 can be soldered to the terminal structure 27.

In addition to that, a DC capacitor and/or snubber circuit may be integrated into the PCB to avoid oscillation during switching, enabling extra fast switching with wide band gap semiconductors.

All connections to the terminal structure 27 may be formed by soldering or sintering. All connections may be formed in a single step.

Figure 5 shows the power module 10 of Figure 4 with an illustration of main power paths in the DC+ and DC- terminal structure in the PCB 19. The main power paths 22, 23 in the PCB 19 are arranged parallel to each other. Thereby, loop inductances cancel out each other such that parasitic stray inductances are reduced.

Figure 6 shows a further embodiment of a power module 10 in a sectional view with a terminal structure 27. The layout may be the same as in the power module 10 of Figure 2.

The difference to the embodiment of Figure 4 is the connection of control signal paths with the terminal structure 27. The connection structure 20 for connecting HS source and LS drain 5a, 3b to an auxiliary terminal is in the form of a press-fit pin inserted in a press-fit receptacle in the terminal structure 27. Also the connection structure 21 connecting the HS gate contact 7b is in the form of a press-fit pin inserted in a press-fit receptacle in the terminal structure. Also the low side gate contact 7a is in the form of a press-fit pin inserted in a press-fit receptacle in the terminal structure.

Also in this embodiment, the power terminals 16, 17 are soldered to the LS and HS switching devices 11, 12.

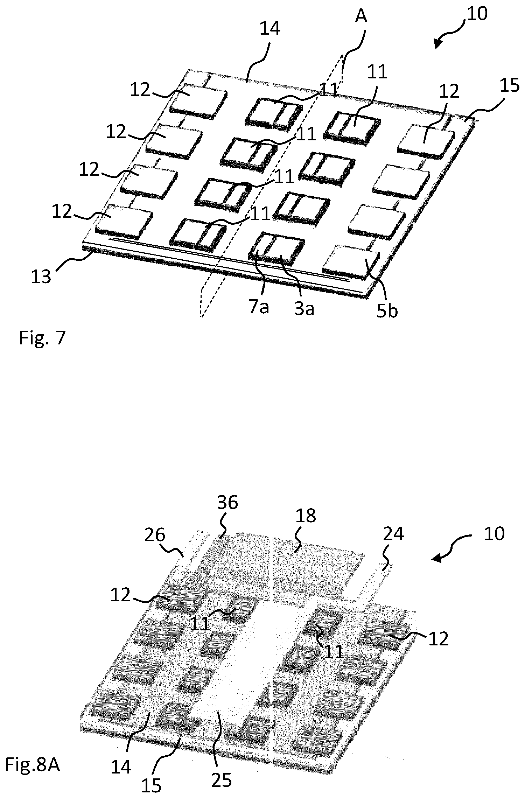

Figure 7 shows a further embodiment of a power module 10 in a perspective view. Also here, low side switching devices 11 and high side switching devices 12 can be formed as identical units 8 as in the foregoing embodiment. Also here, the low side switching devices 11 point with their source contacts 3a upwards and the high side switching devices 11 are flipped and point with their source contacts 3b downwards.

As distinguished from the embodiment of Figure 5, two columns of low side switching devices 11 and two columns of high side switching devices 12 are provided. The layout is mirror-symmetric relative to a plane A perpendicular to a main surface of the substrate 13. Furthermore, the power module 10 comprises four rows instead of two rows.

The power module 10 comprises a metallization 14 on which the drain contacts 5a of the low side switching devices 11 and the source contacts 3a of the high side switching devices 12 are positioned and directly electrically connected thereto. Furthermore, the power module 10 comprises a further metallization 15 on which the gate contacts 7b of the high side switching devices 12 are positioned and directly electrically connected thereto. The further metallization 15 encloses the metallization 14 on three sides.

The switching devices 11, 12 may be connected to the metallizations 14, 15 by chip sintering, for example. Due to the connection structure, no wire bonds are required for connecting chip contacts to metallizations.

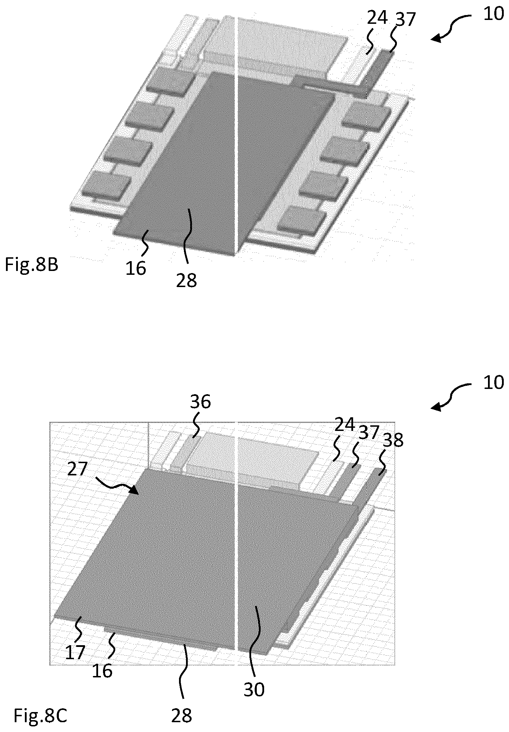

Figures 8A, 8B and 8C show the power module 10 of Figure 7 with a terminal structure 27.

Figure 8A shows the power module 10 with a LS gate terminal 24 connected to gate contacts 7a of the low side switching devices 11. The LS gate terminal 24 is integrally formed with a main connection part 25 in the shape of a strip and is connected to the two columns of LS switching devices 11.

An AC terminal 18 is connected directly to the metallization 14, at an edge of the power module 10. A HS gate terminal 26 is connected directly to the further metallization 15, at an edge of the power module 10. Also an auxiliary terminal 36 is connected directly to the metallization 14.

Figure 8B shows the power module 10 with a DC- terminal 16 connected to source contacts 3b of the low side switching devices 11.

A main connection part 28 integrally formed with the DC-terminal 16 is arranged above the main connection part 25 of the LS gate terminal 24. The main connection part 28 of the DC- terminal 16 has the shape of a plate and completely covers the main connection part 25 of the LS gate terminal 24. The main connection part 28 of the DC- terminal has a broader width such that the source contacts 3b can be directly contacted.

An auxiliary terminal 37 being on the same potential as the DC- terminal 16 is provided at an edge of the power module 10.

Figure 8C shows the power module 10 with a DC+ terminal 17 connected to drain contacts 5b of the high side switching devices 12. A main connection part 30 integrally formed with the DC+ terminal 17 and is arranged above the main connection part 28 of the DC-terminal 16.

A main connection part 30 of the DC+ terminal 17 has the shape of a plate and completely covers the main connection part 28 of the DC- terminal 16. The main connection part 30 of the DC+ terminal 17 has the shape of a plate and completely covers the main connection part 28 of the DC-terminal 16. The main connection part 30 of the DC+ terminal 17 has a broader width than the main connection part 28 of the DC- terminal 16 such that the drain contacts 5b can be directly contacted.

An auxiliary terminal 38 being on the same potential as the DC+ terminal 17 is provided at an edge of the power module 10.

All terminals may be in the form of lead frames. The terminals may be laser-welded to the switching devices 11, 12, for example. The final encapsulation may be done with epoxy molding.

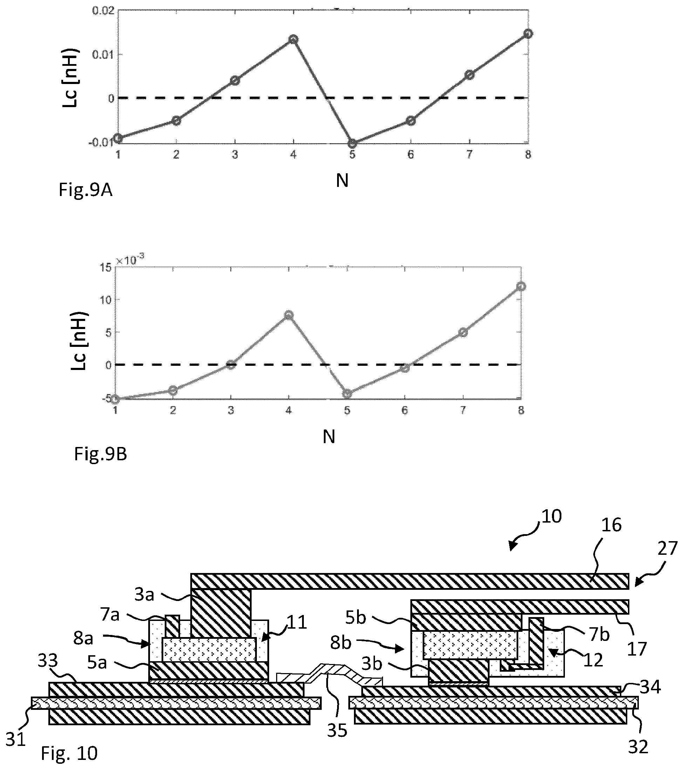

Figure 9A shows the coupling inductance Lc between the associated commutation loop and gate loop for each of the HS switching devices 12 in the embodiment as shown in Figure 7. Figure 9B shows the coupling inductance Lc between the associated commutation loop and gate loop for each of the LS switching devices 11 in the embodiment as shown in Figure 7. The coupling inductance Lc is shown for each of the HS and LS switching devices numbered from 1 to 8.

The coupling inductances are close to zero and show a good balance, both for HS and LS. Furthermore, the design enables a very low stray inductance that is about 0.5 nH. The electromagnetic performance enables higher switching frequencies of wide band gap semiconductors, such as SiC or GaN semiconductors.

Figure 10 shows a power module 10 not in accordance with the claimed invention, as the LS switching device 11 and the HS switching device have a different layout.

As in the previous embodiments, the power module 10 comprises a LS switching device 11 comprising a drain contact 5a pointing towards a first substrate 31, wherein the HS switching device 12 comprises a drain contact 5b pointing in an opposite direction.

As distinguished from the embodiment of Figure 4, the drain contact 5a of the LS switching device 11 is located on and electrically connected to a first metallization 33 and the HS switching device 12 is located on and electrically connected to a separate second metallization 34. The first metallization 33 is electrically connected to the second metallization 34 by an interconnection member 35. The interconnection member 35 may be in the form of a metal clip or wire bond, for example. The interconnection member 35 provides a common AC connection for the LS and HS switching devices 11, 12.

The first metallization 33 is located on a first substrate 31 and the second metallization 34 is located at a separate second substrate 32. The substrates may be assembled on a baseplate (not shown here). The substrates 31, 32 may have identical layouts. The substrates 31, 32 may have a simple layout such that manufacturing costs can be reduced. As shown here, each substrates may only comprise a single metallization 33, 34. The single metallizations 33, 34 provide the AC connection.

As further distinguished from the embodiment of Figure 4, the LS switching device 11 and the HS switching device have a different layout. Both devices may be formed in the form of separate CSP units, for example. The layout of the LS switching device 11 is similar to the layout shown in Figure 1.

The HS switching device 12, however, comprises a gate contact 7b which extends from a side of the semiconductor body 2 at which the source contact 3b is located to a side of the HS switching device 12 at which the drain contact 5b is located. Accordingly, the HS gate contact 7b and the HS drain contact 5b are located and electrically connected to terminals at the same side of the switching device 12.

The LS source contact 3a is connected to a DC- terminal 16 and the HS drain contact 5b is connected to a DC+ terminal 17. The power terminals 16, 17 may be integral parts of a thick copper PCB, for example. The gate contacts 7a, 7b may be electrically connected to gate terminals in the PCB.

The power module 10 may comprise several LS switching devices 11 and several HS switching devices. The LS switching devices 11 may be located on the first metallization 33 and the HS switching devices 12 may be located on the second metallization 34. Several parallel connected LS switching devices 11 may be provided in a single CSP unit and several parallel connected HS switching devices 12 may be provided in a further single CSP unit, for example.

In a method for manufacturing the power module 10 of this example, two distinct different units 8a, 8b for LS and HS switching devices 11, 12 are provided. The units are connected to the separate substrates 31, 32 and can be tested independently. The substrates 31, 32 may have identical designs. After that, the substrates 31, 32 can be assembled on a common baseplate and the metallizations 33, 34 can be electrically connected by an interconnection member 35 to form the half-bridge connection. The interconnection member 35 may be connected by wire bonding, laser welding or ultrasonic welding to the metallizations 33, 34, for example.

In the embodiment shown in Figure 4 and the example shown in Figure 10, the source contacts 3, 3a, 3b and drain contacts 5, 5a, 5b are either directly connected to a terminal 16, 17 or to a metallization 14, 33, 34 on a substrate 13, 31, 32. Also the gate contacts 7, 7a, 7b are either directly connected to a terminal 24, 26 or to a further metallization 15. In this case, wire bond connections are not required in the power module 10. This simplifies the design and reduces the manufacturing cost. In addition to that, the electromagnetic performance can be enhanced.

### Reference Signs

- 1: switching device
- 2: semiconductor body
- 3: source or emitter contact
- 3a: LS source or emitter contact
- 3b: HS source or emitter contact
- 4: first side
- 5: drain or collector contact
- 5a: LS drain or collector contact
- 5b: HS drain or collector contact
- 6: second side
- 7: gate contact
- 7a: LS gate contact
- 7b: HS gate contact
- 8: unit
- 8a: LS unit
- 8b: HS unit
- 9: insulating material
- 10: power module
- 11: LS switching device
- 12: HS switching device
- 13: substrate
- 14: metallization
- 15: further metallization
- 16: DC- terminal
- 17: DC+ terminal
- 18: AC terminal
- 19: printed circuit board (PCB)
- 20: connection structure
- 21: connection structure
- 22: power path (DC-)
- 23: power path (DC+)
- 24: LS gate terminal
- 25: main connection part
- 26: HS gate terminal
- 27: terminal structure
- 28: main connection part of DC- terminal
- 30: main connection part of DC+ terminal
- 31: first substrate
- 32: second substrate
- 33: first metallization
- 34: second metallization
- 35: interconnection member
- 36: HS auxiliary terminal
- 37: LS auxiliary terminal
- 38: further auxiliary terminal

- A: symmetry plane
- Lc: coupling inductance

## Claims

1. A half-bridge power module (10),
comprising one or more substrates (13, 31, 32) with one or more metallizations (14, 33, 34), at least one high side switching device (11) and at least one low side switching device (12) located on the one or more substrates (13, 31, 32), each of the switching devices (11, 12) comprising a source or emitter contact (3, 3a, 3b) on a first side (4) and a drain or collector contact (5, 5a, 5b) on an opposite second side (6),
wherein the drain or collector contact (5, 5a, 5b) of one of the switching devices (11, 12) is oriented towards and electrically connected to one of the metallizations (14, 33, 34) and the source or emitter contact (3, 3a, 3b) of another one of the switching devices (11, 12) is oriented towards and electrically connected to one of the metallizations (14, 33, 34), wherein each of the switching devices (11, 12) is formed by a unit (8, 8a, 8b) in the form of a chip-scale packaged unit,
wherein the units (8, 8a, 8b) forming the low side switching device (11) and the high side switching device (12) have identical structures,
comprising a DC+ terminal (17) and a DC- terminal (16), wherein a part (30) of the DC+ terminal (17) is located between a part (28) of the DC- terminal (16) and the low-side switching device (12) or wherein a part (28) of the DC-terminal (16) is located between a part (30) of the DC+ terminal (17) and the high-side switching device (11), wherein the part (30) of the DC+ terminal (17) comprises a shape of a plate, completely covers the part (28) of the DC-terminal (16) and has a broader width than the part (28) of the DC- terminal (16) or vice versa, wherein the parts (28, 30) are parallel to a main plane of the one or more substrates (13, 31, 32).

2. The half-bridge power module of claim 1, wherein each of the switching devices (11) has a gate contact (7, 7a, 7b), wherein both gate contacts (7, 7a, 7b) are arranged for further connection on the first side (4) of the respective switching device (11, 12).

3. The half-bridge power module of any of the preceding claims, wherein the drain or collector contact (5, 5a, 5b) of the one of the switching devices (11, 12) is connected to the same one of the metallizations (14, 33, 34) as the source or emitter contact (3, 3a, 3b) of the other one of the switching devices (11, 12).

4. The half-bridge power module of any of the preceding claims, comprising several high side switching devices (11) and several low side switching devices (12), wherein the source or emitter contacts (3, 3a, 3b) of the switching devices (11, 12) of the same side are oriented in the same direction.

5. The half-bridge power module of any of the preceding claims, wherein the source or emitter contact (3, 3a, 3b) of the one of the switching devices (11, 12) is connected to a first metallization (33) and the drain or collector contact (5, 5a, 5b) of the other one the switching devices (11, 12) is connected to a different second metallization (34).

6. The half-bridge power module of claim 5,
comprising an interconnection member (35) electrically connecting the first metallization (33) and the second metallization (34).

7. The half-bridge power module of any of claims 5 and 6, wherein the different metallizations are located on different substrates.

8. The half-bridge power module of any of the preceding claims, wherein the switching devices (11, 12) are located between the terminal structure (27) and the one or more substrates (13, 31, 32), wherein each of the source or emitter contacts (3, 3a, 3b) and each of the drain or collector contacts (5, 5a, 5b) is either directly connected to one of the metallizations (14, 33, 34) or to one of the DC- and DC+ terminals (16, 17).

9. The half-bridge power module of any of the preceding claims, wherein the drain or collector contact (5, 5a, 5b) of the low side switching device (11) is oriented towards and electrically connected to one of the metallizations (14, 33, 34) and the source or emitter contact (3, 3a, 3b) of the high side switching device (12) is oriented towards and electrically connected to one of the metallizations (14, 33, 34).

10. A method for manufacturing a half-bridge power module (10), comprising the steps of:
providing one or more substrates (13, 31, 32) with one or more metallizations (14, 33, 34),
at least one high side switching device (11) and at least one low side switching device (12), each of the switching devices (11, 12) comprising a source or emitter contact (3, 3a, 3b) on a first side (4) and a drain or collector contact (5, 5a, 5b) on an opposite second side (6),
locating the switching devices (11, 12) on the one or more substrates (13, 31, 32) such that the drain or collector contact (5, 5a, 5b) of one of the switching devices (11, 12) is oriented towards and electrically connected to one of the metallizations (14, 33, 34) and source or emitter contact (3, 3a, 3b) of the other one of the switching devices (11, 12) is oriented towards and electrically connected to one of the metallizations (14, 33, 34), wherein each of the switching devices (11, 12) is provided by a chip-scale packaged unit;
wherein the units (8, 8a, 8b) forming the low side switching device (11) and the high side switching device (12) have identical structures, wherein the half-bridge power module (10) comprises a DC+ terminal (17) and a DC- terminal (16), wherein a part (30) of the DC+ terminal (17) is located between a part (28) of the DC- terminal (16) and the low-side switching device (12) or wherein a part (28) of the DC-terminal (16) is located between a part (30) of the DC+ terminal (17) and the high-side switching device (11),
wherein the part (30) of the DC+ terminal (17) comprises a shape of a plate, completely covers the part (28) of the DC-terminal (16) and has a broader width than the part (28) of the DC- terminal (16) or vice versa, wherein the parts (28, 30) are parallel to a main plane of the one or more substrates.

## Patentansprüche

1. Halbbrücken-Leistungsmodul (10),
umfassend ein oder mehrere Substrate (13, 31, 32) mit einer oder mehreren Metallisierungen (14, 33, 34), mindestens eine hochseitige Schaltvorrichtung (11) und mindestens eine tiefseitige Schaltvorrichtung (12), die auf dem einen oder den mehreren Substraten (13, 31, 32) angeordnet sind, wobei jede der Schaltvorrichtungen (11, 12) einen Source- oder Emitterkontakt (3, 3a, 3b) auf einer ersten Seite (4) und einen Drain- oder Kollektorkontakt (5, 5a, 5b) auf einer gegenüberliegenden zweiten Seite (6) aufweist,
wobei der Drain- oder Kollektorkontakt (5, 5a, 5b) einer der Schaltvorrichtungen (11, 12) auf eine der Metallisierungen (14, 33, 34) ausgerichtet und elektrisch damit verbunden ist und der Source- oder Emitterkontakt (3, 3a, 3b) einer anderen der Schaltvorrichtungen (11, 12) auf eine der Metallisierungen (14, 33, 34) ausgerichtet und elektrisch damit verbunden ist, wobei jede der Schaltvorrichtungen (11, 12) durch eine Einheit (8, 8a, 8b) in Form einer Chip-Scale-Package-Einheit gebildet wird, wobei die Einheiten (8, 8a, 8b), die die tiefseitige Schaltvorrichtung (11) und die hochseitige Schaltvorrichtung (12) bilden, identische Strukturen aufweisen,
umfassend einen DC+ Anschluss (17) und einen DC- Anschluss (16), wobei ein Teil (30) des DC+ Anschlusses (17) zwischen einem Teil (28) des DC- Anschlusses (16) und der tiefseitigen Schaltvorrichtung (12) angeordnet ist oder wobei ein Teil (28) des DC- Anschlusses (16) zwischen einem Teil (30) des DC+ Anschlusses (17) und der hochseitigen Schaltvorrichtung (11) angeordnet ist,
wobei der Teil (30) des DC+ Anschlusses (17) eine Form einer Platte umfasst, den Teil (28) des DC- Anschlusses (16) vollständig bedeckt und eine größere Breite als der Teil (28) des DC- Anschlusses (16) aufweist oder umgekehrt, wobei die Teile (28, 30) parallel zu einer Hauptebene des einen oder der mehreren Substrate (13, 31, 32) sind.

2. Halbbrücken-Leistungsmodul nach Anspruch 1, wobei jede der Schaltvorrichtungen (11) einen Gatekontakt (7, 7a, 7b) aufweist, wobei beide Gatekontakte (7, 7a, 7b) zur weiteren Verbindung an der ersten Seite (4) der jeweiligen Schaltvorrichtung (11, 12) angeordnet sind.

3. Halbbrücken-Leistungsmodul nach einem der vorhergehenden Ansprüche, wobei der Drain- oder Kollektorkontakt (5, 5a, 5b) der einen der Schaltvorrichtungen (11, 12) mit derselben der Metallisierungen (14, 33, 34) verbunden ist wie der Source- oder Emitterkontakt (3, 3a, 3b) der anderen der Schaltvorrichtungen (11, 12).

4. Halbbrücken-Leistungsmodul nach einem der vorhergehenden Ansprüche, das mehrere hochseitige Schaltvorrichtungen (11) und mehrere tiefseitige Schaltvorrichtungen (12) umfasst, wobei die Source- oder Emitterkontakte (3, 3a, 3b) der Schaltvorrichtungen (11, 12) auf derselben Seite in derselben Richtung ausgerichtet sind.

5. Halbbrücken-Leistungsmodul nach einem der vorhergehenden Ansprüche, wobei der Source- oder Emitterkontakt (3, 3a, 3b) der einen der Schaltvorrichtungen (11, 12) mit einer ersten Metallisierung (33) verbunden ist und der Drain- oder Kollektorkontakt (5, 5a, 5b) der anderen der Schaltvorrichtungen (11, 12) mit einer davon verschiedenen zweiten Metallisierung (34) verbunden ist.

6. Halbbrücken-Leistungsmodul nach Anspruch 5,
umfassend ein Verbindungselement (35), das die erste Metallisierung (33) und die zweite Metallisierung (34) elektrisch verbindet.

7. Halbbrücken-Leistungsmodul nach einem der Ansprüche 5 und 6, wobei die verschiedenen Metallisierungen auf verschiedenen Substraten angeordnet sind.

8. Halbbrücken-Leistungsmodul nach einem der vorhergehenden Ansprüche, wobei die Schaltvorrichtungen (11, 12) zwischen der Anschlussstruktur (27) und dem einen oder den mehreren Substraten (13, 31, 32) angeordnet sind, wobei jeder der Source- oder Emitterkontakte (3, 3a, 3b) und jeder der Drain- oder Kollektorkontakte (5, 5a, 5b) entweder direkt mit einer der Metallisierungen (14, 33, 34) oder mit einem der DC- und DC+ Anschlüsse (16, 17) verbunden ist.

9. Halbbrücken-Leistungsmodul nach einem der vorhergehenden Ansprüche, wobei der Drain- oder Kollektorkontakt (5, 5a, 5b) der tiefseitigen Schaltvorrichtung (11) auf eine der Metallisierungen (14, 33, 34) ausgerichtet und elektrisch damit verbunden ist und der Source- oder Emitterkontakt (3, 3a, 3b) der hochseitigen Schaltvorrichtung (12) auf eine der Metallisierungen (14, 33, 34) ausgerichtet und elektrisch damit verbunden ist.

10. Verfahren zum Herstellen eines Halbbrücken-Leistungsmoduls (10), das die folgenden Schritte umfasst:
Bereitstellen eines oder mehrerer Substrate (13, 31, 32) mit einer oder mehreren Metallisierungen (14, 33, 34),
mindestens eine hochseitige Schaltvorrichtung (11) und mindestens eine tiefseitige Schaltvorrichtung (12), wobei jede der Schaltvorrichtungen (11, 12) einen Source- oder Emitterkontakt (3, 3a, 3b) auf einer ersten Seite (4) und einen Drain- oder Kollektorkontakt (5, 5a, 5b) auf einer gegenüberliegenden zweiten Seite (6) aufweist,
Anordnen der Schaltvorrichtungen (11, 12) auf dem einen oder den mehreren Substraten (13, 31, 32) derart, dass der Drain- oder Kollektorkontakt (5, 5a, 5b) einer der Schaltvorrichtungen (11, 12) auf eine der Metallisierungen (14, 33, 34) ausgerichtet und elektrisch damit verbunden ist und der Source- oder Emitterkontakt (3, 3a, 3b) der anderen der Schaltvorrichtungen (11, 12) auf eine der Metallisierungen (14, 33, 34) ausgerichtet und elektrisch damit verbunden ist, wobei jede der Schaltvorrichtungen (11, 12) durch eine Chip-Scale-Package-Einheit bereitgestellt wird; wobei die Einheiten (8, 8a, 8b), die die tiefseitige Schaltvorrichtung (11) und die hochseitige Schaltvorrichtung (12) bilden, identische Strukturen aufweisen, wobei das Halbbrücken-Leistungsmodul (10) einen DC+ Anschluss (17) und einen DC- Anschluss (16) umfasst, wobei ein Teil (30) des DC+ Anschlusses (17) zwischen einem Teil (28) des DC-Anschlusses (16) und der tiefseitigen Schaltvorrichtung (12) angeordnet ist oder wobei ein Teil (28) des DC- Anschlusses (16) zwischen einem Teil (30) des DC+ Anschlusses (17) und der hochseitigen Schaltvorrichtung (11) angeordnet ist, wobei der Teil (30) des DC+ Anschlusses (17) eine Form einer Platte umfasst, den Teil (28) des DC- Anschlusses (16) vollständig bedeckt und eine größere Breite als der Teil (28) des DC-Anschlusses (16) aufweist oder umgekehrt, wobei die Teile (28, 30) parallel zu einer Hauptebene des einen oder der mehreren Substrate sind.

## Revendications

1. Module de puissance en demi-pont (10),
comprenant un ou plusieurs substrats (13, 31, 32) avec une ou plusieurs métallisations (14, 33, 34), au moins un dispositif de commutation côté haut (11) et au moins un dispositif de commutation côté bas (12) situés sur les un ou plusieurs substrats (13, 31, 32), chacun des dispositifs de commutation (11, 12) comprenant un contact de source ou d'émetteur (3, 3a, 3b) sur un premier côté (4) et un contact de drain ou de collecteur (5, 5a, 5b) sur un second côté opposé (6),
dans lequel le contact de drain ou de collecteur (5, 5a, 5b) de l'un des dispositifs de commutation (11, 12) est orienté vers et connecté électriquement à l'une des métallisations (14, 33, 34) et le contact de source ou d'émetteur (3, 3a, 3b) d'un autre des dispositifs de commutation (11, 12) est orienté vers et connecté électriquement à l'une des métallisations (14, 33, 34), dans lequel chacun des dispositifs de commutation (11, 12) est formé par une unité (8, 8a, 8b) sous la forme d'une unité encapsulée à l'échelle de la puce,
dans lequel les unités (8, 8a, 8b) formant le dispositif de commutation côté bas (11) et le dispositif de commutation côté haut (12) ont des structures identiques,
comprenant une borne DC+ (17) et une borne DC- (16),
dans lequel une partie (30) de la borne DC+ (17) est située entre une partie (28) de la borne DC- (16) et le dispositif de commutation côté bas (12) ou dans lequel une partie (28) de la borne DC- (16) est située entre une partie (30) de la borne DC+ (17) et le dispositif de commutation côté haut (11),
dans lequel la partie (30) de la borne DC+ (17) constitue une forme d'une plaque, couvre complètement la partie (28) de la borne DC- (16) et a une largeur plus grande que la partie (28) de la borne DC- (16) ou vice-versa, dans lequel les parties (28, 30) sont parallèles à un plan principal des un ou plusieurs substrats (13, 31, 32).

2. Module de puissance en demi-pont selon la revendication 1, dans lequel chacun des dispositifs de commutation (11) a un contact de gâchette (7, 7a, 7b), dans lequel les deux contacts de gâchette (7, 7a, 7b) sont agencés pour une connexion supplémentaire sur le premier côté (4) du dispositif de commutation (11, 12) respectif.

3. Module de puissance en demi-pont selon l'une quelconque des revendications précédentes, dans lequel le contact de drain ou de collecteur (5, 5a, 5b) de l'un des dispositifs de commutation (11, 12) est connecté à la même des métallisations (14, 33, 34) que le contact de source ou d'émetteur (3, 3a, 3b) de l'autre des dispositifs de commutation (11, 12).

4. Module de puissance en demi-pont selon l'une quelconque des revendications précédentes, comprenant plusieurs dispositifs de commutation côté haut (11) et plusieurs dispositifs de commutation côté bas (12), dans lequel les contacts de source ou d'émetteur (3, 3a, 3b) des dispositifs de commutation (11, 12) du même côté sont orientés dans la même direction.

5. Module de puissance en demi-pont selon l'une quelconque des revendications précédentes, dans lequel le contact de source ou d'émetteur (3, 3a, 3b) de l'un des dispositifs de commutation (11, 12) est connecté à une première métallisation (33) et le contact de drain ou de collecteur (5, 5a, 5b) de l'autre des dispositifs de commutation (11, 12) est connecté à une seconde métallisation (34) différente.

6. Module de puissance en demi-pont selon la revendication 5,
comprenant un élément d'interconnexion (35) connectant électriquement la première métallisation (33) et la seconde métallisation (34).

7. Module de puissance en demi-pont selon l'une quelconque des revendications 5 et 6, dans lequel les différentes métallisations sont situées sur des substrats différents.

8. Module de puissance en demi-pont selon l'une quelconque des revendications précédentes, dans lequel les dispositifs de commutation (11, 12) sont situés entre la structure de bornes (27) et les uns ou plusieurs substrats (13, 31, 32), dans lequel chacun des contacts de source ou d'émetteur (3, 3a, 3b) et chacun des contacts de drain ou de collecteur (5, 5a, 5b) est directement connecté à l'une des métallisations (14, 33, 34) ou à l'une des bornes DC- et DC+ (16, 17).

9. Module de puissance en demi-pont selon l'une quelconque des revendications précédentes, dans lequel le contact de drain ou de collecteur (5, 5a, 5b) du dispositif de commutation côté bas (11) est orienté vers et connecté électriquement à l'une des métallisations (14, 33, 34) et le contact de source ou d'émetteur (3, 3a, 3b) du dispositif de commutation côté haut (12) est orienté vers et connecté électriquement à l'une des métallisations (14, 33, 34).

10. Procédé de fabrication d'un module de puissance en demi-pont (10), comprenant les étapes consistant à :
munir un ou plusieurs substrats (13, 31, 32) d'une ou de plusieurs métallisations (14, 33, 34),
au moins un dispositif de commutation côté haut (11) et au moins un dispositif de commutation côté bas (12), chacun des dispositifs de commutation (11, 12) comprenant un contact de source ou d'émetteur (3, 3a, 3b) sur un premier côté (4) et un contact de drain ou de collecteur (5, 5a, 5b) sur un second côté (6) opposé,
situer les dispositifs de commutation (11, 12) sur les un ou plusieurs substrats (13, 31, 32) de telle sorte que le contact de drain ou de collecteur (5, 5a, 5b) de l'un des dispositifs de commutation (11, 12) soit orienté vers et connecté électriquement à l'une des métallisations (14, 33, 34) et le contact de source ou d'émetteur (3, 3a, 3b) de l'autre des dispositifs de commutation (11, 12) soit orienté vers et
connecté électriquement à l'une des métallisations (14, 33, 34), dans lequel chacun des dispositifs de commutation (11, 12) est fourni par une unité encapsulée à l'échelle de la puce ; dans lequel les unités (8, 8a, 8b) formant le dispositif de commutation côté bas (11) et le dispositif de commutation côté haut (12) ont des structures identiques, dans lequel le module de puissance en demi-pont (10) comprend une borne DC+ (17) et une borne DC- (16), dans lequel une partie (30) de la borne DC+ (17) est située entre une partie (28) de la borne DC- (16) et le dispositif de commutation côté bas (12) ou dans lequel une partie (28) de la borne DC- (16) est située entre une partie (30) de la borne DC+ (17) et le dispositif de commutation côté haut (11), dans lequel la partie (30) de la borne DC+ (17) constitue une forme d'une plaque, couvre complètement la partie (28) de la borne DC- (16) et a une largeur plus grande que la partie (28) de la borne DC- (16) ou
vice-versa, dans lequel les parties (28, 30) sont parallèles à un plan principal des un ou plusieurs substrats.
